# EUROPÄISCHE PATENTSCHRIFT

(11) **EP 0 842 563 B1**
(45) Veröffentlichungstag und Bekanntmachung des Hinweises auf die Patenterteilung: **12.01.2005**
(21) Anmeldenummer: 97929088.9
(22) Anmeldetag: 03.06.1997
(51) Int. Cl.: H03J 1/00

(54) **VERFAHREN ZUR BEREITSTELLUNG EINES STEUERSIGNALS FÜR DIE STEUERUNG EINES RUNDFUNKEMPFÄNGERS NACH EINEM STANDORTWECHSEL**
PROCESS FOR PROVIDING A CONTROL SIGNAL FOR CONTROLLING A RADIO RECEIVER AFTER A CHANGE IN POSITION
PROCEDE DE PREPARATION D'UN SIGNAL DE COMMANDE POUR LA COMMANDE D'UN RECEPTEUR RADIO APRES UN CHANGEMENT D'EMPLACEMENT

(30) Priorität: 04.06.1996 DE 19622349
(43) Veröffentlichungstag der Anmeldung: 20.05.1998
(73) Patentinhaber: ROBERT BOSCH GMBH, 70442 Stuttgart (DE)
(72) Erfinder: HEGELER, Wilhelm, D-31134 Hildesheim (DE)
(86) Internationale Anmeldenummer: PCT/DE1997/001112
(87) Internationale Veröffentlichungsnummer: WO 1997/047086

(56) Entgegenhaltungen:
- EP-A- 0 092 055
- EP-A- 0 479 613
- GB-A- 2 104 744
- US-A- 4 989 263

## Beschreibung

### Stand der Technik

Es ist bekannt, in programmgesteuerten Rundfunkempfängern Suchläufe nach den an dem jeweiligen Standort empfangswürdigsten Sendefrequenzen zu veranlassen. Die Empfangswürdigkeit einer Sendefrequenz ist bekanntlich u.a. abhängig von der Entfernung zwischen dem Senderstandort und dem Empfängerstandort. Vergrößert sich diese Entfernung, so kann die Empfangswürdigkeit des Senders verloren gehen.

Sind in einem Rundfunkempfänger verschiedene Sendefrequenzen gespeichert, deren Einschaltung über das Bedienteil willkürlich wechselbar ist, dann ist es u.a. auch nützlich zu wissen, ob sich die Entfernung zwischen Sender und Empfänger zwischen zwei aufeinanderfolgenden Einschaltzeitpunkten derselben Sendefrequenz wesentlich geändert hat, ob also inzwischen ein wesentlicher Standortwechsel des Empfängers stattgefunden hat. Mit größeren und häufigeren Standortwechseln ist besonders bei Autoradios zu rechnen.

GB-A-2 104 744 offenbart einen Rundfunkernpfänger mit einem automatischen Sendersuchlauf, in dessen Rahmen empfangene Rundfunkfrequenzen zusammen mit einer Qualitätsbewertung in einem Rundfunkfrequenzspeicher abgelegt werden. Für den Fall, dass sämtliche Speicherplätze des Speichers bereits belegt sind, werden im Falle einer im Rahmen des Sendersuchlaufs ermittelten weiteren Rundfunkfrequenz, die eine höhere Empfangsqualität aufweist, als eine bereits im Speicher abgelegte Frequenz, diese bereits im Speicher abgelegte Rundfunkfrequenz durch die neu aufgefundene, eine höhere Empfangsqualität aufweisende Rundfunkfrequenz ersetzt.

### Vorteile der Erfindung

Das im unabhängigen Verfahrensanspruch gekennzeichnete Verfahren ist in der Lage, ein Signal bereitzustellen, das Informationen über einen Standortwechsel enthält.

In den abhängigen Patentansprüchen sind Weiterbildungen des Verfahrens angegeben.

Der unabhängige. Sachanspruch kennzeichnet Elemente eines Rundfunkempfängers, die zur Durchführung des Verfahrens erforderlich sind.

### Zeichnung

In der Zeichnung zeigt
- Fig. 1: ein Blockschaltbild eines zur Durchführung des Verfahrens eingerichteten programmgesteuerten Rundfunkempfängers,
- Fig. 2: ein Blockschaltbild eines Teils eines Mikroprozessoraufbaus zur Durchführung des Verfahrens.

### Beschreibung

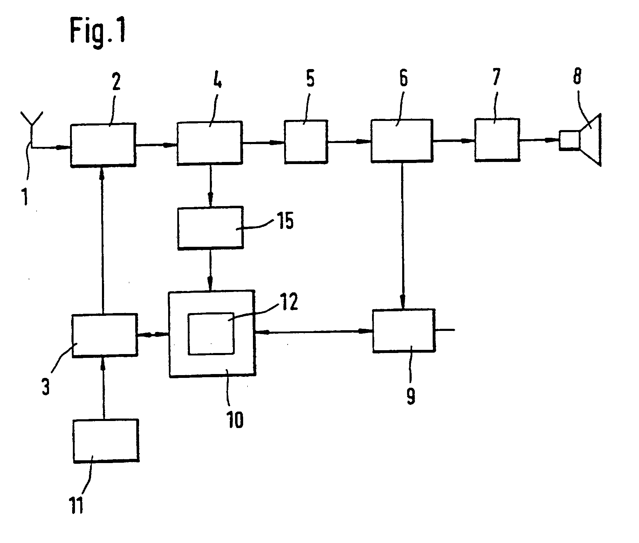

Der in Fig. 1 als Blockschaltbild dargestellte Rundfunkempfänger empfängt das ganze Spektrum der Sendefrequenzen über eine Antenne 1. In einer Mischstufe 2 wird dem Antennensignal eine im Mischoszillator 3 erzeugte Mischfrequenz überlagert. Dabei entsteht eine mit dem MPX-Signal einer bestimmten Sendefrequenz modulierte Zwischenfrequenz. Diese Zwischenfrequenz wird in einer ZF-Stufe 4 verstärkt. Danach wird das MPX-Signal in einem Demodulator 5 von der Zwischenfrequenz getrennt und durchläuft dann eine Frequenzweiche 6. An einem der Ausgänge der Frequenzweiche 6 ist eine NF-Stufe 7 angeschlossen, die einen Lautsprecher 8 speist, der das durch Wahl der Mischfrequenz eingestellten Programm zu Gehör bringt.

An einem zweiten Ausgang der Frequenzweiche 6 ist ein RDS-Decoder 9 angeschlossen, der die RDS-Signale in dem MPX-Signal von einem 57-kHz-Hilfsträger trennt und die verschiedenen RDS-Signale an zugeordneten Ausgängen verfügbar macht.

Die Decodierung der RDS-Signale in dem RDS-Decoder 9 wird von einem ersten Teilprogramm des Mikroprozessors 10 gesteuert.

Ein zweites Teilprogramm des Mikroprozessors 10 steuert die jeweilige Einstellung des Mischoszillators 3, die unter anderem über ein Bedienteil 11 willkürlich veränderbar ist. Mit diesem Bedienteil wird z. B. das gewünschte Programm gewählt oder ein Suchvorgang (Best, Search, Travel) eingeleitet.

Ein drittes Teilprogramm des Mikroprozessors 10 steuert das Verfahren zur Bereitstellung eines Steuersignals für die Steuerung des Rundfunkempfängers bei einem signifikanten Standortwechsel des Rundfunkempfängers.

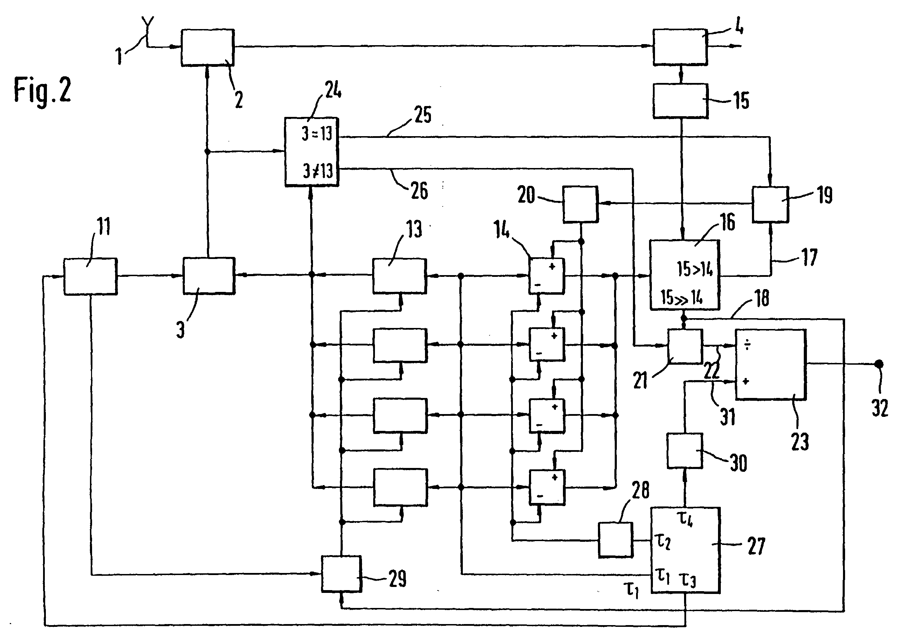

Zur Durchführung des Verfahrens verfügt der Rundfunkempfänger über einen Baustein 12, dessen Aufbau in Fig. 2 näher dargestellt ist. Dieser Baustein 12 kann sowohl in den Mikroprozessor 10 integriert sein, als auch Bestandteil des Bedienteils 11 bilden.

Der mit dem Mischoszillator 3 verbundene Baustein 12 umfaßt unter anderem vier separate Speicher 13 für vier Sendefrequenzen und vier zugeordnete Speicher 14 für die Empfangsqualität dieser Sendefrequenzen bei deren Einstellung in dem Mischoszillator 3. Diese Empfangsqualität, für die im einfachsten Fall die Empfangsfeldstärke als Maß dient, wird in einer Meßstufe 15 gemessen, die an die ZF-Stufe 4 angeschlossen ist. Die vier gespeicherten Sendefrequenzen dienen als Kontrollsendefrequenzen.

Zum Baustein 12 gehört eine erste Vergleichsstufe 16, in welcher der in den Speichern 14 gespeicherte Wert der Empfangsqualität mit dem momentanen Meßergebnis der Meßstufe45 verglichen werden kann. Die Vergleichsstufe 16 hat zwei Bewertungszustände, deren erster am Ausgang 17 einen Meßwert anzeigt, der größer ist als der Speicherwert, deren zweiter am Ausgang 18 einen Meßwert anzeigt, der wesentlich über dem Speicherwert liegt, z. B. um 30 dBµV.

Der Ausgang 17 ist über eine erste Torschaltung 19 mit einer ersten Steuerstufe 20 verbunden, der Ausgang 18 über eine zweite Torschaltung 21 mit einem Eingang 22 eines Zählers 23.

Beide Torschaltungen 19 und 21 werden von zwei unterschiedlichen Ausgängen einer zweiten Vergleichsstufe 24 gesteuert. Am Ausgang 25 der Vergleichsstufe 24 läßt sich ein Steuersignal abnehmen, wenn die von dem Mischoszillator 3 eingestellte Sendefrequenz einer der im Speicher 13 gespeicherten Kontrollsendefrequenz entspricht (3 = 13). Am Ausgang 26 der Vergleichsstufe 24 zeigt sich ein Signal, wenn die eingestellte Sendefrequenz eine Nicht-Kontrollsendefrequenz ist (3 ≠ 13).

Von Zeit zu Zeit (n x τ₁) werden über einen Taktgeber 27 die vier Kontrollsendefrequenzen nacheinander eingestellt (3 = 13) - unabhängig davon, ob eine der Kontrollsendefrequenzen oder eine Nicht-Kontrollsendefrequenz gerade zu Gehör gebracht wird. Dabei wird jeweils die momentane Empfangsqualität gemessen und mit der im Speicher 14 gespeicherten Empfangsqualität der eingestellten Kontrollsendefrequenz verglichen. Ist die momentane Empfangsqualität besser als die gespeicherte Empfangsqualität, dann wird über die Torschaltung 19 und die erste Steuerstufe 20 dieser bessere Wert in den zugehörigen Speicher 14 eingelesen, d. h. der gespeicherte Wert wird aufgewertet.

Zwischen zwei Prüfgängen der Empfangsqualität der Kontrollsendefrequenzen, d. h. zu den Zeitpunkten n x τ₂, werden ebenfalls vom Taktgenerator 27 gesteuert, die in den Speichern 14 enthaltenen Werte um einen in einer zweiten Steuerstufe 28 vorgegebenen Betrag gleichzeitig vermindert. D. h. während einer längeren Zeitspanne werden die in den Speichern 14 gespeicherten Werte kontinuierlich abgewertet. Nach mehreren Abwerteschritten ergibt sich, daß die Empfangsqualität einer Kontrollsendefrequenz mit nahezu gleichbleibender Empfangsqualität wieder neu gespeichert wird, weil sich die empfangene Empfangsqualität als besser erweist als der abgewertete, gespeicherte Wert.

In vorgegebenen Zeitabständen τ₃, ebenfalls gesteuert vom Taktgeber 27, wird auch die Empfangsqualität der über das Bedienteil 11 eingestellten Sendefrequenz des gehörten Programms mit den in den Speichern 14 gespeicherten Werten in der Vergleichsstufe 16 verglichen (3 ≠ 13). Erweist sich dieser Wert als wesentlich größer ggü. einem der in den Speichern 14 gespeicherten Werte, dann wird über eine dritte Torschaltung 29 vom Ausgang 18 der Vergleichsstufe 16 die vom Bedienteil 11 her eingestellte Nicht-Kontrollsendefrequenz des gehörten Programms gegen die bisher gespeicherte Kontrollsendefrequenz ausgetauscht.

Dasselbe passiert, wenn während eines Suchvorganges eine neue starke Sendefrequenz gefunden wird.
Mit dem gleichem Signal wird über die zweite Torschaltung 21 der Stand des Zählers 23 vermindert, z. B. halbiert.

Dazwischen, zu den Zeitpunkten n x τ₄, wird der Stand des Zählers 23 über den Eingang 31 regelmäßig um einen in der dritten Steuerstufe 30 vorgegebenen relativ kleinen Betrag erhöht.

An dem Ausgang 32 des Zählers 23 steht das Steuersignal bereit, das Informationen über einen Standortwechsel enthält.

Dies ergibt sich aus folgenden Überlegungen, die anhand der Situation eines in ein Kraftfahrzeug eingebauten Autoradios, welches sich in flacher Gegend bewegt, erläutert wird. Diese Überlegungen können aber auf jeden mobilen Rundfunkempfänger übertragen werden.

An dem Ausgangsstandort des Fahrzeuges und in seiner näheren Umgebung ist ein bestimmtes Sendefrequenzspektrum empfangbar. Beim Einschalten des Autoradios seien in den vier Speichern 13 und 14 vier Sendefrequenzen aus diesem Spektrum mit ihrer Bewertung gespeichert. Von Zeit zu Zeit, z. B. im Abstand von τ₁ = 12 Minuten, wird die Empfangsqualität der vier Kontrollsendefrequenzen überprüft. Am Ausgangsstandort und in seiner näheren Umgebung wird dabei in aller Regel die inzwischen abgewertete Bewertung wieder aufgewertet, weil sich die Empfangsqualität dort nicht wesentlich verändert.

Entfernt sich dagegen das Autoradio weiter von seinem Ausgangsstandort, dann ist bekanntlich damit zu rechnen, daß sich die Empfangsqualität eines oder mehrerer Kontrollsendefrequenzen verschlechtert und bei der Überprüfung die Bewertung nicht wieder aufgewertet wird.

Während der ganzen Fahrtdauer wird der Stand des Zählers 23 kontinuierlich im Zeitabstand τ₄ erhöht.

Wie bereits erwähnt, wird die Bewertung der Kontrollsendefrequenzen in vorgegebenen größeren Zeitabständen τ₃ mit der Bewertung der Sendefrequenz des eingestellten Programms oder der beim Suchlauf gefundenen Sendefrequenz verglichen. Ist deren Bewertung wesentlich besser als eine der Kontrollsendefrequenzen, d. h. zumindesten der schwächsten Kontrollsendefrequenz, z. B. um 30 dBµV in der Feldstärke, dann erfolgt, wie weiter oben bereits erwähnt, ein Austausch der schwächsten Kontrollsendefrequenz gegen die stärkere Nicht-Kontroll-Sendefrequenz. Bei diesem Austausch wird auch der Stand des Zählers 23 erniedrigt, z. B. um den Faktor 1/2.

Aus diesem neuen niedrigen Zählerstand läßt sich in der Regel auf eine zunehmende Entfernung des Fahrzeuges von seinem Ausgangsstandort schließen.

Je größer die Entfernung wird, um so mehr Kontrollsendefrequenzen werden gegen neue Sendefrequenzen ausgetauscht, wobei jedesmal der Stand des Zählers 23 erniedrigt wird. Mit anderen Worten, die Abnahme des Zählerstandes, die Abweichung von seinem Maximum stellt eine Information, d. h. ein Steuersignal über einen Standortwechsel des Autoradios dar. Hält sich das Fahrzeug mit dem Autoradio anschließend längere Zeit an dem neuen Standort auf, dann erfolgt kein Wechsel unter den Kontrollsendefrequenzen mehr und der Zähler 23 kann ungestört, z. B. alle 12 Minuten, um den vorgegebenen Betrag hochgezählt werden.

Eine Zunahme des Zählerstand bzw. das Erreichen des Maximums ist also eine Information über das längere Verweilen des Fahrzeuges an einen Standort oder in dessen näherer Umgebung. Ein längeres Verbleiben an einem neuen Standort begründet einen "neuen" Ausgangsstandort, auch "Heimat" genannt.

In der Umgebung von Hochhäusern oder in bergiger Gegend sind häufiger Feldstärkeeinbrüche zu verzeichnen, ohne daß sich das Autoradio entsprechend weit aus seiner Heimat entfernt hat. Dem Umstand kann man entweder durch Wahl der Zeitabstände der Überprüfung der Kontrollsender Rechnung tragen oder durch die Erniedrigung des Zählerstandes erst nach wiederholter Feststellung der Bedingungen für einen Wechsel bei den Kontrollsendern.

Die in der Zeichnung dargestellten Schaltblöcke stehen für bestimmte Funktionen, die bei der Durchführung der beschriebenen Verfahren zu realisieren sind.
Sie können auch durch geeignete Befehlsstrukturen im Mikroprozessorprogramm verwirklicht werden und stellen keine Beschränkung der Erfindung dar.

## Patentansprüche

1. Verfahren zur Bereitstellung eines einen Standortwechsel eines Rundfunkempfängers anzeigenden Signals,
wobei im Rundfunkempfänger eine Anzahl n als empfangswürdig bewerteter Kontrollsendefrequenzen gespeichert und in vorgegebenen Zeitabständen zur Neubewertung wieder eingestellt werden,
wobei von Zeit zu Zeit die Bewertung der Empfangsqualität einer eingestellten Nicht-Kontrollsendefrequenz mit den Bewertungen der Empfangsqualität der Kontrollsendefrequenzen verglichen wird,
wobei bei wesentlicher höherer Bewertung der Empfangsqualität einer Nicht-Kontrollsendefrequenz gegenüber der Bewertung mindestens einer der Kontrollsendefrequenzen diese höher bewertete Sendefrequenz anstelle einer Kontrollsendefrequenz gespeichert wird,
wobei ein Zählerstand eines Zählers einerseits in vorgegebenen Zeitabständen um einen vorgegebenen Betrag erhöht wird und andererseits bei einem Austausch einer Kontrollsendefrequenz durch eine Nicht-Kontrollsendefrequenz um einen vorgegebenen Faktor reduziert wird, und
wobei die Zählerstandsreduzierung den Standortwechsel anzeigt.

2. Verfahren nach Anspruch 1, **dadurch gekennzeichnet, dass** bei höherer Bewertung einer Nicht-Kontrollsendefrequenz gegenüber mindestens einer der Kontrollsendefrequenzen diese höher bewerte Sendefrequenz anstelle der am geringsten bewerteten Kontrollsendefrequenz gespeichert wird.

3. Verfahren nach Anspruch 1 oder 2, **dadurch gekennzeichnet, dass** der Zählerstand des Zählers (23) in vorgegebenen Zeitabständen solange erhöht wird, bis er ein Maximum erreicht hat,
und dass erst eine vorgegebene Abweichung des Zählerstandes von seinem Maximum ein Steuersignal auslöst.

4. Verfahren nach einem der vorhergehenden Ansprüche, **dadurch gekennzeichnet, dass** bei einer Neubewertung eine Verbesserung der Empfangsqualität der jeweiligen Kontrollsendefrequenz gespeichert wird,
und dass zwischen den Neubewertungen die Empfangsqualität aller Kontrollsendefrequenzen um einen vorgegebenen Betrag abgewertet wird.

5. Rundfunkempfänger zur Durchführung eines Verfahrens zur Bereitstellung eines einen Standortwechsel eines Rundfunkempfängers anzeigenden Signals, wobei im Rundfunkempfänger eine Anzahl n als empfangswürdig bewerteter Kontrollsendefrequenzen gespeichert und in vorgegebenen Zeitabständen zur Neubewertung wieder eingestellt werden, wobei von Zeit zu Zeit die Bewertung der Empfangsqualität einer eingestellten Nicht-Kontrollsendefrequenz mit den Bewertungen der Empfangsqualität der Kontrollsendefrequenzen verglichen wird, wobei bei wesentlich höherer Bewertung der Empfangsqualität einer Nicht-Kontrollsendefrequenz gegenüber der Bewertung mindestens einer der Kontrollsendefrequenzen diese höher bewertete Sendefrequenz anstelle einer Kontrollsendefrequenz gespeichert wird, und wobei aus dem Austausch einer Kontrollsendefrequenz durch eine Nicht-Kontrollsendefrequenz das Signal abgeleitet wird,
mit einem Speicher (13) für n Kontrollsendefrequenzen und mit damit verbundenen Speichern (14) für den Wert ihrer Empfangsqualität,
mit einem Zähler (23), der vom Zählerstand abhängige Ausgangssignale erzeugt und
mit einem Mikroprozessor (10) mit einem Teilprogramm, welches den Zählerstand in vorgegebenen Zeitabständen um einen vorgegebenen Betrag erhöht und bei Austausch einer Kontrollsendefrequenz um einen vorgegebenen Faktor reduziert.

## Claims

1. Process for providing a signal which indicates a change of location of a radio receiver, in which, a number n are stored in the radio receiver as test transmission frequencies which are evaluated as being worth receiving and are set again at predefined time intervals for re-evaluation,
the weighting of the reception quality of a non-test transmission frequency which has been set is compared from time to time with the weightings of the reception quality of the test transmission frequencies,
when the reception quality of a non-test transmission frequency is given a significantly higher weighting than the weighting of at least one of the test transmission frequencies this transmission frequency with the higher weighting is stored instead of a test transmission frequency,
a counter reading of a counter is, on the one hand, increased by a predefined absolute value at predefined time intervals and, on the other hand, reduced by a predefined factor when the test transmission frequency is replaced by a non-test transmission frequency, and
the reduction in the counter reading indicates the change of location.

2. Method according to Claim 1, **characterized in that**, when a non-test transmission frequency is given a higher weighting than at least one of the test transmission frequencies, this transmission frequency which has a higher weighting is stored instead of the test transmission frequency which has the lowest weighting.

3. Method according to Claim 1 or 2, **characterized in that** the counter reading of the counter (23) is increased at predefined time intervals until it has reached a maximum value, and **in that** a control signal is not triggered until there is a predefined deviation of the counter reading from its maximum value.

4. Method according to one of the preceding claims, **characterized in that**, when there is a re-evaluation, an improvement in the reception quality of the respective test transmission frequency is stored, and **in that** the weighting of the reception quality of all the test transmission frequencies is reduced by a predefined absolute value between the re-evaluations.

5. Radio receiver for carrying out a method for providing a signal which indicates a change of location of a radio receiver, during which a number n is stored in the radio receiver as test transmission frequencies which are evaluated as worth receiving and are set again at predefined time intervals for re-evaluation, from time to time the weighting of the reception quality of a non-test transmission frequency which has been set is compared with the weightings of the reception quality of the test transmission frequencies, when the reception quality of a non-test transmission frequency has a significantly higher weighting than the weighting of at least one of the test transmission frequencies this transmission frequency with the higher weighting is stored instead of a test transmission frequency, and the signal is derived from the replacement of a test transmission frequency by a non-test transmission frequency,
having a memory (13) for n test transmission frequencies and having memories (14) which are connected thereto, for the value of their reception quality,
having a counter (23) which generates output signals which are dependent on the counter reading, and
having a microprocessor (10) with a program component which increases the counter reading by a predefined absolute value at predefined time intervals and reduces it by a predefined factor when a test transmission frequency is replaced.

## Revendications

1. Procédé de préparation d'un signal indiquant un changement d'emplacement d'un récepteur radio selon lequel,
on met en mémoire dans le récepteur radio un certain nombre (n) de séquences d'émission de contrôle susceptibles d'être reçues et on les règle de nouveau dans des intervalles de temps prédéfinis pour une nouvelle exploitation,
de temps en temps on compare, l'exploitation de la qualité de réception d'une fréquence d'émission de non contrôle, réglée avec l'exploitation de la qualité de réception des fréquences d'émission de contrôle,
pour une exploitation significativement plus élevée de la qualité de réception d'une fréquence d'émission de non contrôle par rapport à l'exploitation d'au moins l'une des fréquences d'émission de contrôle, on enregistre en mémoire cette fréquence d'émission exploitée au niveau le plus élevé à la place d'une fréquence d'émission de contrôle,
on augmente l'état de comptage d'un compteur d'une part dans des intervalles de temps prédéfinis, d'une valeur prédéfinie et, d'autre part, en cas de remplacement d'une fréquence d'émission de contrôle on réduit une fréquence d'émission de non contrôle d'un coefficient prédéfini, et
la réduction de l'état de comptage indique le changement d'emplacement.

2. Procédé selon la revendication 1,
**caractérisé en ce que**
pour une exploitation supérieure d'une fréquence d'émission de non contrôle par rapport à au moins une fréquence d'émission de contrôle, on enregistre cette fréquence d'émission exploitée à un niveau plus élevé à la place de la fréquence d'émission de contrôle exploitée au niveau le plus faible.

3. Procédé selon l'une quelconque des revendications 1 ou 2,
**caractérisé en ce qu'**
on augmente l'état de comptage du compteur (23) dans des intervalles de temps prédéfinis jusqu'à atteindre un maximum, et
une première déviation prédéfinie de l'état de comptage par rapport à son maximum déclenche un signal de commande.

4. Procédé selon l'une quelconque des revendications précédentes,
**caractérisé en ce que**
lors d'une nouvelle exploitation on enregistre en mémoire une amélioration de la qualité de réception de la fréquence d'émission de contrôle respective, et
entre les nouvelles exploitations on diminue d'une valeur prédéfinie la qualité de réception de toutes les séquences d'émission de contrôle.

5. Récepteur radio pour la mise en oeuvre d'un procédé fournissant un signal indiquant un changement d'emplacement de récepteur radio selon lequel on enregistre en mémoire dans le récepteur radio un nombre (n) de séquences d'émission de contrôle méritant d'être exploitées et dans des intervalles de temps prédéfinis, on règle de nouveau pour une nouvelle exploitation, et
de temps en temps on compare l'exploitation de la qualité de réception d'une fréquence d'émission de non-contrôle, réglée avec l'exploitation de la qualité de réception des fréquences d'émission de contrôle, et
pour une exploitation significativement plus élevée de la qualité de réception d'une fréquence d'émission de non-contrôle par rapport à l'exploitation d'au moins l'une des fréquences d'émission de contrôle, on enregistre en mémoire la fréquence d'émission exploitée au niveau le plus élevé à la place d'une fréquence d'émission de contrôle, et
à partir du remplacement d'une fréquence d'émission de contrôle par une fréquence d'émission de non contrôle on déduit le signal, comprenant une mémoire (13) pour les (n) fréquences d'émission de contrôle et d'une mémoire (14) associées à celle-ci pour la valeur de la qualité de réception,
un compteur (23) qui génère des signaux d'émission dépendant de l'état de comptage et
un microprocesseur (10) avec un programme partiel augmentant l'état de comptage d'une amplitude prédéterminée à des intervalles de temps donnés, et en cas de remplacement d'une fréquence d'émission de contrôle, l'état de comptage est diminué d'une valeur prédéfinie.
